# EUROPEAN PATENT APPLICATION

(11) **EP 4 080 423 A1**
(43) Date of publication of application: **26.10.2022**
(21) Application number: 21169862.6
(22) Date of filing: 22.04.2021
(51) Int. Cl.: G06Q 10/00, G06Q 50/02

(54) **COMPUTER-IMPLEMENTED METHOD AND DATA MANAGEMENT SYSTEM FOR EXECUTING DATA MANAGEMENT OF PRODUCTION GOODS**

(71) Applicant: Siemens Aktiengesellschaft, 80333 München (DE)
(72) Inventor: Baldauf, Manfred, 91056 Erlangen (DE); Runkler, Thomas, 81929 München (DE); Steinbacher, Frank, 90542 Eckental (DE); Stoelben, Gunnar, 90763 Fürth (DE)

(57) **Abstract**

In order to execute data management of production goods, by which the data being yielded in each phase of a production good-lifecycle is managed such that it can be used by any stakeholder and at changes in a data structure due to evolutionary production process of the good to optimize or certificate the production good and/or the production thereof, it is proposed to use lifecycle- data (LCD, LCD1, LCD2, ... LCDn) of a production good (PG) across a production good lifecycle and thereby
**(1)** decentrally storing the lifecycle-data (LCD, LCD1, LCD2, ... LCDn) and providing access to the stored lifecycle-data (LCD) through a "Peer-to-Peer-Network"-based blockchain technology (P2P-NW, NWN) for various stakeholders (SH1, ... SHn) involved in a production good-lifecycle and participated regarding the "blockchain technology"-based storage and access as network nodes (NWN),
**(2)** selectively accessing the lifecycle-data (LCD, LCD1, LCD2, ... LCDn) through a cryptographic, in particular hierarchical, mechanism with a public key (PUK) and a private key (PRK, PRK1, PRK2), by which each stakeholder (SH1, ... SHn) is able to grant or deny the access, in particular for different stakeholders, and
**(3)** enabling a dynamic data structure of the lifecycle-data (LCD) through a knowledge graph (KG) based on entities (ENT, ENT1, ENT2, ... ENT9) being related to one other via edges (EDG, EDG1, EDG2, ... EDG8), assigned attributes (ATR, ATR1, ATR2, ... ATR8) and brought into thematic context or ontologies (OTG) .

## Description

The invention refers to a method for executing data management of production goods according to the preamble claim 1 and a data management system for executing data management of production goods according to the preamble claim 7.

For a comprehensive data management of production goods one can hardly do this without the consideration up to the inclusion of a production good-lifecycle. The production good-lifecycle comprises a production of raw materials and components, a manufacturing of modules and products, logistics and transportation as well as operation, reuse, recycling, and disposal of a good. Each step of this production good-lifecycle potentially yields valuable data that can be used to optimize or to certificate the good or similar goods of the same family and its or their production, e.g. with regard to ecological footprint assessment, recycling rates, etc.

So let us consider for example - as typical production goods of numerous other possible goods - electrical energy storages, such as primary or secondary cells, primary or secondary batteries. A battery production comprises many production steps. Each production step requires the specification of many production parameters, e.g. chemical, physical, electrical, etc. parameters, that significantly influence operation characteristics of the battery such as capacity, cell voltage, charging behavior, stress resilience, lifetime, etc. Therefore, for example, information about the expected operation modes of a battery will allow battery producers to optimize the production parameters in order to (i) improve the battery quality and (ii) improve the efficiency of the production process.

Other examples could be that information about the battery parameters would help manufacturers of electric cars to optimize charging and discharging profiles or the battery's bill of materials could help recycling companies to increase yield of recycled materials.

Other benefits could be production optimization by analysis of performance data from field applications or documentation of carbon footprint and other environmental or societal impact factors, e.g. water and land consumption, labor conditions, over product lifetime. In general, each stakeholder across the product life cycle has potential advantages by data from other steps of the product life cycle.

Up to now, many stakeholders across the production good-lifecycle collect their own data and only use them to optimize their own processes. For example, factories track their production parameters and resulting product qualities in order to optimize their production. However, production data are often considered highly confidential, so there is very little willingness to share these data with other stakeholders or to provide access to these data in a hosted data platform. Moreover, production processes or legislation evolve over time, which leads to changes in the data structure, so no fixed data base format will be feasible.

It is an objective of the invention to propose a computer-implemented method and a data management system for executing data management of production goods, by which the data being yielded in each phase of a production good-lifecycle is managed such that it can be used by any stakeholder and at changes in a data structure due to evolutionary production process of the good to optimize or certificate the production good and/or the production thereof.

This objective is solved with regard to a computer-implemented method defined in the preamble of claim 1 by the features in the characterizing part of claim 1.

Moreover the objective is solved by a computer-implemented tool carrying out the computer-implemented method according to claim 6.

The objective is further solved with regard to a data management system defined in the preamble of claim 7 by the features in the characterizing part of claim 7.

The main idea of the invention according to the claims 1 and 7 - in order to execute a data management - is the use of lifecycle-data across a lifecycle of a production good wherein the data usage is based on a decentralized, secure and open data platform.
Hereby, the data usage is given by
(**1**) decentrally storing lifecycle-data and providing access to the stored lifecycle-data through a "Peer-to-Peer-Network"-based blockchain technology for various stakeholders involved in a production good-lifecycle and participated regarding the "blockchain technology"-based storage and access as network nodes,
(**2**) selectively accessing the lifecycle-data through a cryptographic, in particular hierarchical, mechanism with a public key and a private key, by which each stakeholder is able to grant or deny the access, in particular for different stakeholders, and
(**3**) enabling a dynamic data structure of the lifecycle-data through a knowledge graph (KG) based on entities being related to one other via edges, assigned attributes and brought into thematic context or ontologies.

This leads to a manner of data management with three important properties:
- the data storage is realized in a decentralized way with no central repository to store the data,
- the access to the data is selective, so that the data owner (the stakeholder who has stored the data) has the right to grant or deny the data access to specific partners (stakeholders). So there can be separate classes for data with restricted and non-restricted access because some data shall only be available for controlled exchanges, e.g. between manufacturer and user, while others need to be open to everyone. The latter might be needed to fulfill either certain legislative requirements, compliance with regulation, legislation, carbon footprint and/or other limitations or documentation of mandatory recycling rates.
- the data structure must be dynamic and allow arbitrary changes over time without violating data consistency.

Regarding (1): The blockchain technology (already successfully used in supply chain management, such as food supply or freight transport) provides each stakeholder in the production good-lifecycle access to the complete relevant lifecycle-data, which is resistant to modification and tampering.
Regarding (2): With the selective access to the product lifecycle data the data owner contributes cryptographic information to the blockchain and may grant or may deny data access by providing the necessary keys.
Regarding (3): The knowledge graph represents graph structured data models that specify properties of objects and relations between objects and allows flexible modifications of the data model structure without violating data consistency.

Due to this approach the stakeholder can provide his data in a decentralized, secure and flexible way and he is able to use such data across the production good-lifecycle to optimize products and production. Moreover the approach is distinguished by oneself through the following advantages:
(A) The stakeholder does not have to trust a central data host, because the data are stored in a decentral blockchain.
(B) The stakeholder can grant or deny data access to selected other stakeholders (partners), which allows the definition of new business models. For example, when the production good is an electrical energy storage, e.g. a primary or secondary battery, a battery manufacturer may offer a discount to e-car owners if they grant access to their operation data.
(C) The stakeholder may flexibly change the data format. For example - when the production good is an electrical energy storage, e.g. a primary or secondary battery, - if a battery producer changes the production process by introducing an additional production step, this additional step and its production parameters and data may be easily included in the existing knowledge graph format. Another reason for data structure flexibility could be new stakeholders coming into play due to developing new markets with separate norms and standards or due to new legislation.

Further advantageous developments of the invention are given by the independent claims.

Moreover, additional advantageous developments of the invention arise out of the following description of a preferred embodiment of the invention according to FIGURES 1 to 3. They show:
FIGURE 1 a data management system for executing data management of a production good,
FIGURE 2 in the context of the data management system depicted in the FIGURE 1 a knowledge graph to structure dynamically data,
FIGURE 3 a computer-implemented tool carrying out a data management execution.

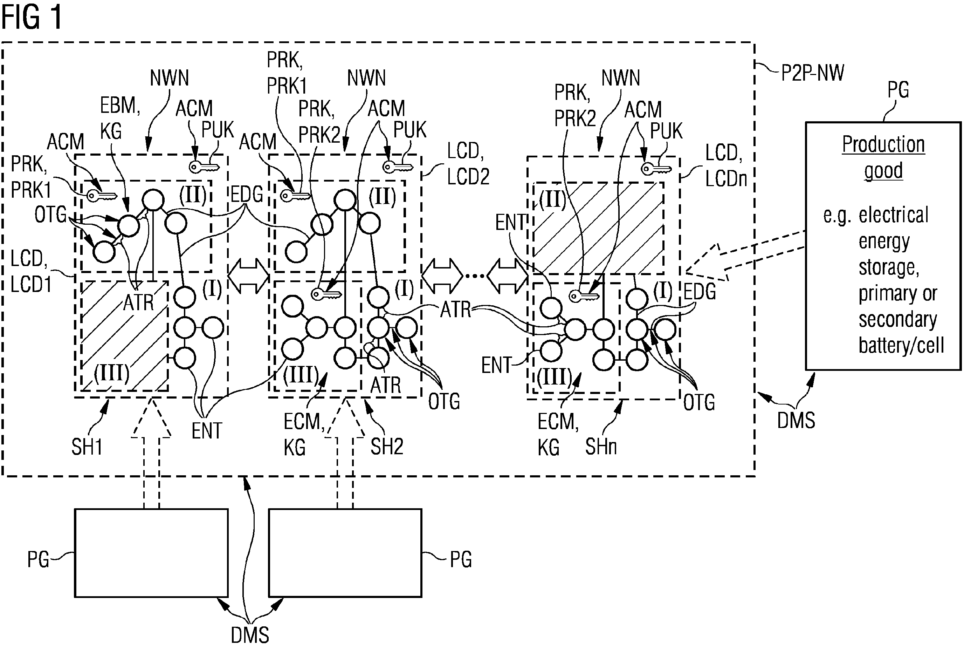

FIGURE 1 shows a data management system DMS for executing data management of a production good PG. The depicted production good PG is preferably an electrical energy storage and as such a primary cell/battery or a secondary cell/battery. Having said this it is also possible to have instead of the electrical energy storage any other product as the production good.

Central component of the data management system DMS is a peer-to-peer-network P2P-NW with network nodes NWN. By this peer-to-peer-network P2P-NW a blockchain technology is implemented in order to decentrally store for various stakeholders SH1, ... SHn and with regard to a production good-lifecycle of the production good PG corresponding data, so called lifecycle-data LCD, which is stored correspondingly in a decentral blockchain. For this reason there is no longer - as in the state of the art - a central repository necessary to store the lifecycle-data LCD.

The blockchain technology, which is already known from supply chain management, such as food supply or freight transport, provides each stakeholder SH1, ... SHn in the production good-lifecycle access to the complete relevant lifecycle-data LCD, which is resistant to modification and tampering.

This manner of decentrally storing lifecycle-data LCD is depicted in the FIGURE 1 by dash-lined arrows. So for a first stakeholder SH1 first lifecycle-data LCD1, for a second stakeholder SH2 second lifecycle-data LCD2 and for a n-th stakeholder SHn n-th lifecycle-data LCDn are stored.

As the production good PG also the production good-lifecycle is preferably a lifecycle of the electrical energy storage respectively the primary cell/battery or the secondary cell/battery.

Due to the blockchain technology the stakeholders SH1, SH2, ... SHn as the network nodes NWN of the peer-to-peer-network P2P-NW, involved in a production good-lifecycle and participated in the "blockchain technology"-based storage have access to the stored lifecycle-data LCD, LCD1, LCD2, ... LCDn.

This access however is selective. So, there are accessing means ACM to access selectively the stored lifecycle-data LCD, LCD1, LCD2, ... LCDn. For this purpose the accessing means ACM comprise a cryptographic mechanism with a public key PUK and a private key PRK, by which the access can be controlled selectively. This cryptographic mechanism is preferably hierarchical. Based on the selective access to the lifecycle data LCD, LCD1, LCD2, ... LCDn the stakeholder who has stored the data, called as data owner, contributes cryptographic information to the blockchain and in this way may grant or may deny data access by providing the cited keys PUK, PRK. Due to this selective access the data owner can or has the right to grant or deny the data access to other stakeholders, which are specific (business) partners. So there can be separate classes for data with restricted and non-restricted access because some data shall only be available for controlled exchanges, e.g. between manufacturer and user, while others need to be open to everyone. The latter might be needed to fulfill either certain legislative requirements, compliance with regulation, legislation, carbon footprint and/or other limitations or documentation of mandatory recycling rates.

In the FIGURE 1 this granting access authorization is depicted as follows:
1. The second lifecycle-data LCD2 stored in the blockchain for the stakeholder SH2 are accessible such that
   - regarding a first part (I) the access for a public group of stakeholders (e.g. all stakeholders) is allowed by using the public key PUK,
   - regarding a second part (II) the access for a first private group of stakeholders (e.g. a limited number of stakeholders) is allowed by using a first private key PRK1 and
   - regarding a third part (III) the access for a second private group of stakeholders is allowed by using a second private key PRK2.
   Thereby the first private group of stakeholders and the second private group of stakeholders are preferably different stakeholders.
2. The first lifecycle-data LCD1 stored in the blockchain for the stakeholder SH1 are accessible such that
   - regarding the first part (I) the access for the public group of stakeholders by using the public key PUK,
   - regarding the second part (II) the access for the first private group of stakeholders is allowed by using the first private key PRK1 and
   - regarding the third part (III) the access is denied.
   The denied access is depicted in the FIGURE 1 by the third part (III) being shown hatched.
3. The n-th lifecycle-data LCDn stored in the blockchain for the stakeholder SHn are accessible such that
   - again regarding the first part (I) the access for the public group of stakeholders is allowed by using the public key PUK,
   - regarding the second part (II) the access is denied and
   - regarding the third part (III) the access for the second private group of stakeholders is allowed by using the second private key PRK2.

The denied access is depicted by the third part (III) being shown hatched.

When the production good PG is the electrical energy storage respectively the primary cell/battery or the secondary cell/battery, the lifecycle-data LCD, LCD1, LCD2, ... LCDn thereof include preferably at least one of production parameters, operation information, analyzed performance data from field applications and documentation data such as "carbon footprint and other environmental or societal impact factors, e.g. water and land consumption, labor conditions, over lifetime", raw material sources or recycling quota.

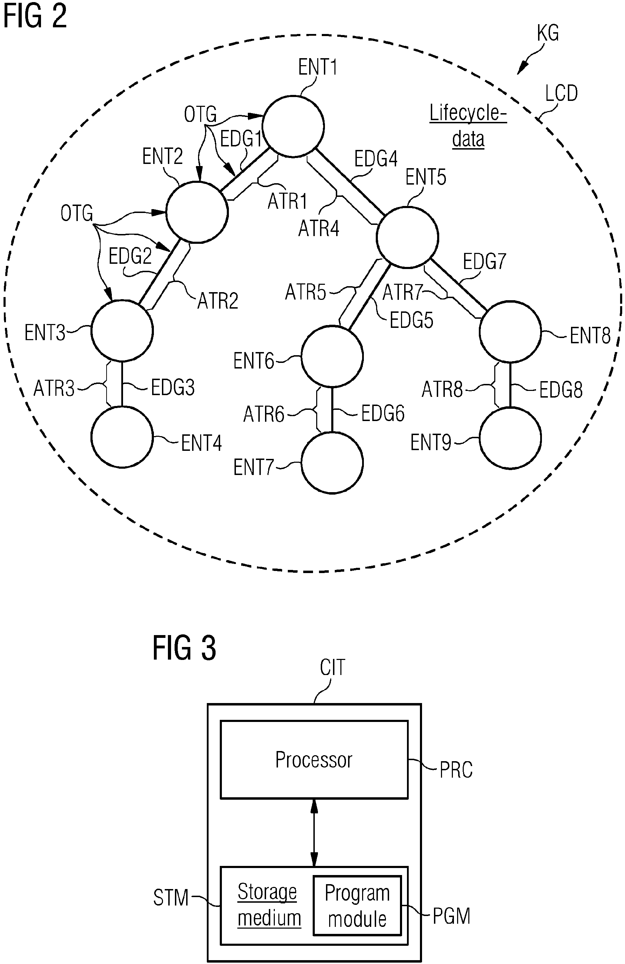

Furthermore regarding the lifecycle-data LCD, LCD1, LCD2, ... LCDn there are enabling means EBM to enable a dynamic data structure of the lifecycle-data through a knowledge graph KG. This knowledge graph KG - as it will be depicted and described with respect to FIGUR 2 - is based on entities ENT being related to one other via edges EDG, assigned attributes ATR and brought into thematic context or ontologies OTG. Thereby the dynamic data structure allow arbitrary changes over time without violating data consistency. For this purpose the knowledge graph KG represents graph structured data models that specify properties of objects and relations between objects and allows flexible modifications of the data model structure without violating data consistency.

FIGURE 2 shows in the context of the data management system depicted in the FIGURE 1 the knowledge graph KG to structure dynamically data and in particular the lifecycle-data LCD. The knowledge graph KG is designed as a tree structure with nodes and edges, wherein the nodes are the entities ENT and the edges are the already mentioned edges EDG. According to depiction in the FIGURE 2 the data respectively the lifecycle-data LCD comprises a tree structure with nine entities ENT1, ... ENT9 and eight edges EDG1, ...EDG8. Moreover the depicted knowledge graph KG also contains eight attributes ATR1, ....ATR8 and numerous ontologies OTG. In the present context an ontology in the field of information technology and computer science is a way of showing properties or attributes of a production good and how these properties or attributes are related, by defining a set of concepts and categories that represent the lifecycle-data of the production good. So, according to the depicted knowledge graph in the FIGURE 2 a first attribute ATR1 and a fourth attribute ATR4 are assigned to a first entity ENT1, wherein a second attribute ATR2 and the first attribute ATR1 are assigned to a second entity ENT2, wherein the first entity ENT1 and the second entity ENT2 are being related by the first edge EDG1 and wherein all the information is brought into a data model, the ontology OTG.

FIGURE 3 a computer-implemented tool CIT carrying out a data management execution. The computer-implemented tool CIT contains for this purpose
- a non-transitory, processor-readable storage medium STM having processor-readable program-instructions of a program module PGM for carrying out the data management execution stored in the non-transitory, processor-readable storage medium STM and
- a processor PRC connected with the storage medium STM executing the processor-readable program-instructions of the program module PGM to carry out the data management execution.

## Claims

1. Computer-implemented method for executing data management of production goods, by which lifecycle-data (LCD, LCD1, LCD2, ... LCDn) of a production good (PG) is stored for data accesses,
**characterized by**:
**a**) decentrally storing the lifecycle-data (LCD, LCD1, LCD2, ... LCDn) and providing access to the stored lifecycle-data (LCD, LCD1, LCD2, ... LCDn) through a "Peer-to-Peer-Network"-based blockchain technology (P2P-NW, NWN) for various stakeholders (SH1, ... SHn) involved in a production good-lifecycle and participated regarding the "blockchain technology"-based storage and access as network nodes (NWN),
**b**) selectively accessing the lifecycle-data (LCD, LCD1, LCD2, ... LCDn) through a cryptographic, in particular hierarchical, mechanism with a public key (PUK) and a private key (PRK, PRK1, PRK2) by which each stakeholder (SH1, ... SHn) is able to grant or deny the access, in particular for different stakeholders,
**c**) enabling a dynamic data structure of the lifecycle-data (LCD) through a knowledge graph (KG) based on entities (ENT, ENT1, ENT2, ... ENT9) being related to one other via edges (EDG, EDG1, EDG2, ... EDG8), assigned attributes (ATR, ATR1, ATR2, ... ATR8) and brought into thematic context or ontologies (OTG) .

2. Method according to claim 1, **characterized in that**
the lifecycle-data (LCD, LCD1, LCD2, ... LCDn) is stored in a decentral blockchain.

3. Method according to claim 1 or 2, **characterized in that**
the production good (PG) is an electrical energy storage, in particular a primary cell/battery or a secondary cell/battery.

4. Method according to claim 3, **characterized in that**
the production good-lifecycle is a lifecycle of the electrical energy storage respectively the primary cell/battery or the secondary cell/battery.

5. Method according to claim 3 or 4, **characterized in that**
the lifecycle-data (LCD, LCD1, LCD2, ... LCDn) of the electrical energy storage respectively the primary cell/battery or the secondary cell/battery include at least one of production parameters, operation information, analyzed performance data from field applications and documentation data such as "carbon footprint and other environmental or societal impact factors, e.g. water and land consumption, labor conditions, over lifetime", raw material sources or recycling quota.

6. Computer-implemented tool (CIT) for carrying out the computer-implemented method according to one of the claims 1 to 5, with
- a non-transitory, processor-readable storage medium (STM) having processor-readable program-instructions of a program module (PGM) for carrying out the computer-implemented method stored in the non-transitory, processor-readable storage medium (STM) and
- a processor (PRC) connected with the storage medium (STM) executing the processor-readable program-instructions of the program module (PGM) to carry out the computer-implemented method according to one of the claims 1 to 5.

7. Data management system (DMS) for executing data management of production goods, by which lifecycle-data (LCD, LCD1, LCD2, ... LCDn) of a production good (PG) is stored for data accesses,
**characterized by**:
**a**) a peer-to-peer-network (P2P-NW) with network nodes (NWN) implementing blockchain technology to store decentrally the lifecycle-data (LCD, LCD1, LCD2, ... LCDn) and to provide access to the stored lifecycle-data (LCD, LCD1, LCD2, ... LCDn) for various stakeholders (SH1, ... SHn) involved in a production good-lifecycle and participated regarding the "blockchain technology"-based storage and access as network nodes (NWN),
**b**) accessing means (ACM) to access selectively the lifecycle-data (LCD) through a cryptographic, in particular hierarchical, mechanism with a public key (PUK) and a private key (PRK, PRK1, PRK2) by which each stakeholder (SH1, ... SHn) is able to grant or deny the access, in particular for different stakeholders,
**c**) enabling means (EBM) to enable a dynamic data structure of the lifecycle-data (LCD) through a knowledge graph (KG) based on entities (ENT, ENT1, ENT2, ... ENT9) being related to one other via edges (EDG, EDG1, EDG2, ... EDG8), assigned attributes (ATR, ATR1, ATR2, ... ATR8) and brought into thematic context or ontologies.

8. Data management system (DMS) according to claim 7,
**characterized in that**
the lifecycle-data (LCD, LCD1, LCD2, ... LCDn) is stored in a decentral blockchain.

9. Data management system (DMS) according to claim 7 or 8,
**characterized in that**
the production good (PG) is an electrical energy storage, in particular primary cell/battery or secondary cell/battery.

10. Data management system (DMS) according to claim 9,
**characterized in that**
the production good-lifecycle is a lifecycle of the electrical energy storage respectively the primary cell/battery or the secondary cell/battery.

11. Data management system (DMS) according to claim 9 or 10,
**characterized in that**
the lifecycle-data (LCD, LCD1, LCD2, ... LCDn) of the electrical energy storage respectively the primary cell/battery or the secondary cell/battery include at least one of production parameters, operation information, analyzed performance data from field applications and documentation data such as "carbon footprint and other environmental or societal impact factors, e.g. water and land consumption, labor conditions, over lifetime", raw material sources or recycling quota.
